# EUROPEAN PATENT APPLICATION

(11) **EP 1 720 232 A2**
(43) Date of publication of application: **08.11.2006**
(21) Application number: 06290263.0
(22) Date of filing: 15.02.2006
(51) Int. Cl.: H02J 17/00

(54) **Black matrix composition for plasma display panel and plasma display panel**

(30) Priority: 16.02.2005 KR 2005012938
(71) Applicant: LG Electronics Inc., Seoul 150-721 (KR)
(72) Inventor: Jeon, Wonseok, Neulpureun Byoksan Apt. 101-303, Suwon-si Gyeonggi-do (KR)
(74) Representative: Vignesoult, Serge L. M.

(57) **Abstract**

A black matrix composition and a plasma display panel comprising a black matrix formed of the black matrix composition are provided. The black matrix composition comprises 20 to 85 weight percent, based on total weight of the black matrix composition, of photo cross linkable organics, 10 to 40 weight percent, based on total weight of the black matrix composition, of inorganic pigment, and 5 to 40 weight percent, based on total weight of the black matrix composition, of glass powder.

## Description

### BACKGROUND OF THE INVENTION

### Field of the Invention

The present invention relates to a black matrix composition for a plasma display panel and a plasma display panel.

### Description of the Background Art

A conventional plasma display panel comprises a front panel and a rear panel. Barrier ribs formed between the front panel and the rear panel form discharge cells. Each of the cells is filled with a main discharge gas such as neon (Ne), helium (He) or a Ne-He gas mixture and an inert gas containing a small amount of xenon (Xe).

Discharges of the inert gases are generated by a high frequency voltage supplied to the plasma display panel, while the discharges of the inert gases emit vacuum ultraviolet rays. Vacuum ultraviolet rays make phosphors formed between the barrier ribs emit light, which forms images corresponding to image data on the plasma display panel.

Since the plasma display panel can be manufactured to be thin and light, the plasma display panel has been considered as a next generation display apparatus.

The conventional plasma display panel comprises a black matrix to block off light and improve purity and contrast. The black matrix is formed by firing a black matrix composition formed according to a black matrix pattern.

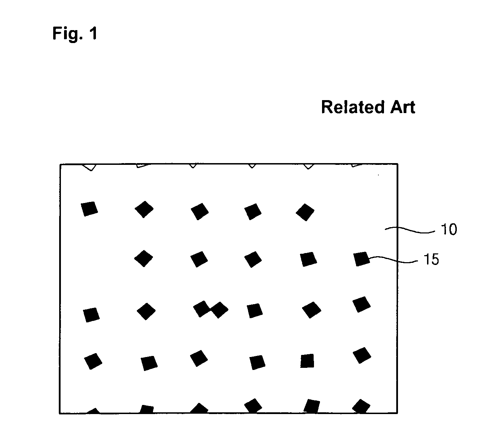

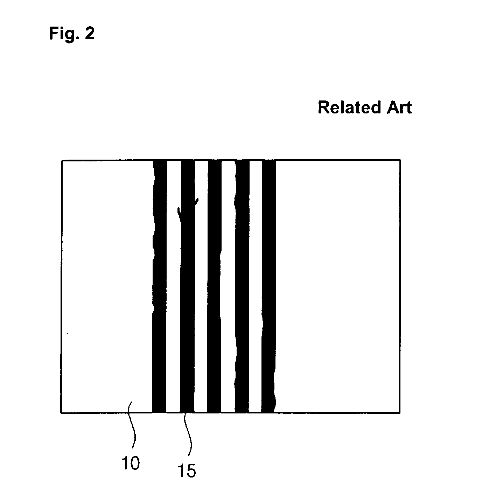

As shown in Fig.1, when a black matrix(15) is formed with a conventional black matrix composition, an adhesive force between a substrate(10) and the black matrix(15) decreases, and the black matrix(15) is cut off. As shown in Fig.2, when a black matrix(15) is formed with a conventional black matrix composition, an adhesiveness between a substrate(10) and the black matrix(15) decreases, a width of the black matrix(15) is not uniform, and an edge of the black matrix(15) is separated from the substrate(10).

A conventional black matrix composition requires too much time to form the black matrix. Further, the thickness of the black matrix is not uniform due to the conventional black matrix composition.

### SUMMARY OF THE INVENTION

Accordingly, an object of the present invention is to solve at least the problems and disadvantages of the related art.

Embodiments of the present invention provide a black matrix composition capable of reducing the time required for forming a black matrix and a plasma display panel comprising a black matrix formed of the black matrix composition.

The embodiments of the present invention also provide a black matrix composition capable of increasing adhesion of a black matrix and a plasma display panel comprising a black matrix formed of the black matrix composition.

The embodiments of the present invention also provide a black matrix composition with good coatability and a plasma display panel comprising a black matrix formed of the black matrix composition.

The embodiments of the present invention also provide a black matrix composition with a high hardening rate and a plasma display panel comprising a black matrix formed of the black matrix composition.

According to an aspect of the present invention, there is provided a black matrix composition for a plasma display panel comprising 20 to 85 weight percent, based on total weight of the black matrix composition, of photo cross linkable organics, 10 to 40 weight percent, based on total weight of the black matrix composition, of inorganic pigment, and 5 to 40 weight percent, based on total weight of the black matrix composition, of glass powder, wherein the photo cross linkable organics comprises 0.5 to 30 weight percent, based on total weight of the photo cross linkable organics, of urethane acrylate oligomer.

According to another aspect of the present invention, there is provided a plasma display panel comprising a substrate, a black matrix formed on the substrate and an electrode layer formed on the black matrix, wherein a width of one surface of the black matrix contacting with the substrate, is more than the width of the other surface of the black matrix contacting with the electrode layer.

The black matrix composition and the plasma display panel according to the embodiments of the present invention increase an adhesiveness of the black matrix.

The black matrix composition and the plasma display panel according to the embodiments of the present invention improve coatability of the black matrix composition.

The black matrix composition and the plasma display panel according to the embodiments of the present invention increase a hardening rate of the black matrix composition.

The black matrix composition and the plasma display panel according to the embodiments of the present invention reduce the time required for forming the black matrix composition.

### BRIEF DESCRIPTION OF THE DRAWINGS

The accompany drawings, which are included to provide a further understanding of the invention and are incorporated in and constitute a part of this specification, illustrate embodiments of the invention and together with the description serve to explain the principles of the invention. In the drawings:

FIG. 1 and FIG. 2 show a black matrix formed with a conventional black matrix composition.

FIG. 3 shows a pattern of a black matrix formed of a black matrix composition according to example 1 of the present invention;

FIG. 4 shows a pattern of a black matrix formed of a black matrix composition according to example 2 of the present invention;

FIG. 5 shows a structure of a plasma display panel according to an embodiment of the present invention.

### DETAILED DESCRIPTION OF PREFERRED EMBODIMENTS

Reference will now be made in detail to embodiments of the present invention, examples of which are illustrated in the accompanying drawings.

A black matrix composition for a plasma display panel according to an embodiment of the present invention comprises 20 to 85 weight percent, based on total weight of the black matrix composition, of photo cross linkable organics, 10 to 40 weight percent, based on total weight of the black matrix composition, of inorganic pigment, and 5 to 40 weight percent, based on total weight of the black matrix composition, of glass powder, wherein the photo cross linkable organics comprises 0.5 to 30 weight percent, based on total weight of the photo cross linkable organics, of urethane acrylate oligomer.

The photo cross linkable organics may further comprise 15 to 55 weight percent, based on total weight of the photo cross linkable organics, of acrylic polymer, 20 to 40 weight percent, based on total weight of the photo cross linkable organics, of photosensitive monomer and 4 to 15 weight percent, based on total weight of the photo cross linkable organics, of photopolymer initiator.

A number average molecular weight of the urethane acrylate oligomer may range from 500 to 40,000.

The inorganic pigment may comprise either a metal based inorganic pigment or a metal oxide based inorganic pigment.

Number-average molecular weight of the acrylic polymer may range from 1,000 to 100,000.

The acrylic polymer may comprise either terpolymer of benzyl methacylate, methacrylic acid and hydroxyethylmethacrylate, or terpolymer of benzyl methacylate, methacrylic acid and methyl methacrylate.

The photosensitive monomer may comprise mono-functional monomer comprising one acrylate functional group.

The photosensitive monomer may comprise mono-functional monomer comprising one acrylate function group, and multi-functional monomer comprising two or more acrylate functional groups.

The photosensitive monomer may comprise mono-functional monomer comprising one acrylate function group and silane based monomer.

The photosensitive monomer may comprises two or more multi-functional monomers and each of the multi-functional monomers may comprise two or more acrylate functional groups.

The multi-functional monomer may comprise any one of propylene glycol diacrylate, pentaerythritol triacrylate and dipentaerythritol hexaacrylate.

The glass powder may comprise either a lead oxide based compound or a bismuth based compound.

The photopolymer initiator may comprise either benzophenone based initiator or trizine based initiator.

The black matrix composition for the plasma display panel may be either a black matrix paste or a black matrix slurry.

A plasma display panel according to another embodiment of the present invention comprises a substrate, a black matrix formed on the substrate and an electrode layer formed on the black matrix, wherein a width of one surface of the black matrix contacting with the substrate, is more than the width of the other surface of the black matrix contacting with the electrode layer.

The horizontal distance between the edge of the one surface and the edge of the other surface, may be more than or equal to 0.1 *µ*m to equal to or less than 10 *µ*m.

The horizontal distance between the edge of the one surface and the edge of the other surface, may be more than or equal to 5 *µ*m to equal to or less than 10 *µ*m.

The black matrix may be formed with a black matrix paste or a black matrix slurry, and the black matrix paste or the black matrix slurry may comprise photo cross linkable organics comprising urethane acrylate oligomer, inorganic pigment and glass powder.

The photo cross linkable organics may range from 20 to 85 weight percent based on total weight of the black matrix composition, and the inorganic pigment may range from 10 to 40 weight percent based on total weight of the black matrix composition, and the glass powder may range from 5 to 40 weight percent based on total weight of the black matrix composition, and wherein the urethane acrylate oligomer may range from 0.5 to 30 weight percent based on total weight of the photo cross linkable organics.

The photo cross linkable organics may further comprises 15 to 55 weight percent, based on total weight of the photo cross linkable organics, of acrylic polymer, 20 to 40 weight percent, based on total weight of the photo cross linkable organics, of photosensitive monomer and 4 to 15 weight percent, based on total weight of the photo cross linkable organics, of photopolymer initiator.

A number-average molecular weight of the urethane acrylate oligomer may range from 500 to 40,000.

The black matrix paste or the black matrix slurry may further comprise at least one of a labeling agent, a silane based coupling agent, an anti-foaming agent, a plasticizer, a dispersing agent, or a dispersion maintaining agent.

Hereinafter, exemplary embodiments of the present invention will be described in detail with reference to the attached drawings.

The black matrix composition according to the embodiment of the present invention comprises 20 to 85 weight percent, based on total weight of the black matrix composition, of a photo cross linkable organics, 10 to 40 weight percent, based on total weight of the black matrix composition, of inorganic pigment, and 5 to 40 weight percent, based on total weight of the black matrix composition, of glass powder.

The inorganic pigment is used to increase a black level of the black matrix 106. The inorganic pigment comprises either a metal based inorganic pigment or a metal oxide based inorganic pigment such as Co₃O₄. When a content of the inorganic pigment is less than 10 weight percent, a black level of the plasma display panel decreases so that contrast of the plasma display panel decreases. When the content of the inorganic pigment is more than 40 weight percent, efficiency of a photo initiator decreases so that a photo-hardening rate of the black matrix decreases.

The glass powder used in the embodiment of the present invention comprises either a lead oxide based compound or a bismuth (Bi) based compound. A content of the glass powder used for the firing process is dependent on the amount used and the size of the inorganic pigment. It is preferable that 5 to 40 weight percent, based on total weight of the black matrix composition, of the glass powder is used. When a content of the glass powder is less than 5 weight percent, the black matrix composition is fired insufficiently so that the inorganic pigment is separated from the fired black matrix. When the content of the glass powder is more than 40 weight percent, there is a problem in that the black level and photo-characteristics of the black matrix decrease.

The photo cross linkable organics comprises 15 to 55 weight percent, based on total weight of the photo cross linkable organics, of acrylic polymer, 20 to 40 weight percent, based on total weight of the photo cross linkable organics, of photosensitive monomer, 0.5 to 30 weight percent, based on total weight of the photo cross linkable organics, of urethane acrylate oligomer and 4 to 15 weight percent, based on total weight of the photo cross linkable organics, of photopolymer initiator.

The urethane acrylate oligomer is manufactured by polymerizing polyether polyol, hydroxyl radical-containing acrylic derivatives and a disocianate compound. Both ends of the urethane acrylate oligomer have a carbon-carbon double bond. Number-average molecular weight of the polyether polyorpreferably ranges from 300 to 30,000, and more preferably, from 500 to 10,000. The disocianate compound is used in a urethane compound. Further, the disocianate compound comprises aliphatic disocianate or aromatic disocianate.

It is preferable that number-average molecular weight of the urethane acrylate oligomer ranges from 500 to 40,000. More preferably, the number-average molecular weight of the urethane acrylate oligomer ranges from 500 to 30,000. When the number-average molecular weight of the urethane acrylate oligomer is less than 500, it is difficult to achieve the improvement of characteristics in the embodiment of the present invention. When the number-average molecular weight of the urethane acrylate oligomer is more than 40,000, there is a problem in that the photo-hardening and the alkali development of the black matrix is adversely affected. The urethane acrylate oligomer of which number-average molecular weight ranges from 500 to 40,000, decreases an amount of light for forming a black matrix pattern from 300 mj(mili-joule) to 100 mj.

0.5 to 30 weight percent, based on total weight of the photo cross linkable organics, of the urethane acrylate oligomer is used. In the embodiment of the present invention, the weight percent means weight percent of a solid powder except a solvent. When a content of the urethane acrylate oligomer is less than 0.5 weight percent, it is difficult to achieve the improvement of the characteristics in the embodiment of the present invention. When the content of the urethane acrylate oligomer is more than 30 weight percent, the problem of the photo-hardening of the black matrix is generated. The urethane acrylate oligomer comprised in the black matrix composition according to the embodiment of the present invention, improves and an anti moisture-absorption.

The acrylic polymer is generally used in a resin composition for hardening ultraviolet rays. The acrylic polymer is used as a matrix binder. Examples of the acrylic polymer include terpolymer of benzyl methacylate, methacrylic acid and hydroxyethylmethacrylate, terpolymer of benzyl methacylate, methacrylic acid and methylmethacrylate. However, the acrylic polymer is not limited thereto.

It is preferable that molecular weight of the acrylic polymer ranges from 1,000 to 100,000. More preferably, the molecular weight of the acrylic polymer ranges from 1,000 to 50,000. When the molecular weight of the acrylic polymer is less than 1,000, a function of the black matrix is not achieved satisfactorily. When the molecular weight of the acrylic polymer is more than 100,000, the problems of the photo-hardening rate and alkali development of the black matrix are generated.

It is preferable that 15 to 55 weight percent, based on total weight of the photo cross linkable organics, of the acrylic polymer is used. When the acrylic polymer is less than 15 weight percent, it is difficult to form the black matrix. Thus, problems of the photo-hardening, the development, pigment dispersion of the black matrix are generated. When the acrylic polymer is more than 55 weight percent, problems of the development and the photo-hardening of the black matrix are generated.

Since the photosensitive monomer used in the embodiment of the present invention has the carbon-carbon double bond, a material capable of performing radical polymerization is used as the photosensitive monomer.

The photosensitive monomer may comprise mono-functional monomer comprising one acrylate function group. Further, the photosensitive monomer may comprise mono-functional monomer comprising one acrylate function group and multi-functional monomer comprising two or more acrylate functional goups.

Examples of the multi-functional monomer include di-functional monomer such as propylene glycol diacrylate, tri-functional monomer such as pentaerythritol triacrylate, hexa-functional monomer such as dipentaerythritol hexaacrylate. However, the multi-functional monomer is not limited thereto. It is preferable that when a hardening material with relatively low elasticity is required, a mono-functional compound is used. However, a multi-functional compound is added to the mono-functional compound at the appropriate ratio so that the elasticity of the hardening material can be adjusted.

Further, the photosensitive monomer may comprise the mono-functional monomer comprising one acrylate function group, and silane based monomer.

It is preferable that 20 to 40 weight percent, based on total weight of the photo cross linkable organics, of the photosensitive monomer is used. When a content of the photosensitive monomer is out of the above-described range, a problem of a photo-hardening system is generated.

The photopolymer initiator used in the embodiment of the present invention comprises benzophenone based initiator and trizine based initiator. A sensitizer such as isopropyl thioxanthone can be added to the photopolymer initiator for the promotion of an effective photoreaction.

It is preferable that 4 to 15 weight percent, based on total weight of the photo cross linkable organics, of the photopolymer initiator is used. When content of the photopolymer initiator is less than 4 weight percent, it is very difficult to achieve photo-hardening of the black matrix. Moreover, when content of the photopolymer initiator is more than 15 weight percent, a problem of photo-hardening is generated and the remaining photopolymer initiator is used as a foreign material.

In the embodiment of the present invention, a small amount of additive such as a labeling agent, a silane based coupling agent, an anti-foaming agent, a plasticizer, a dispersing agent, a dispersion maintaining agent can be added to the black matrix composition.

The black matrix composition according to the embodiment of the present invention is either a black matrix paste or a black matrix slurry.

When the black matrix is formed with the black matrix composition according to the embodiment of the present invention, an amount of light for forming a black matrix pattern, decreases from 300 mj(mili-joule) to 100 mj.

Hereinafter, exemplary embodiments of the present invention will be described in detail with reference to the attached drawings.

[Example 1]

As acrylic polymer used as a binder, 120 g of terpolymer having molecular weight of 39,000 comprising 60 part by weight of benzyl methacylate, 20 part by weight of methacrylic acid and 20 part by weight of hydroxyethylmethacrylate was used. Further, 50 part by weight of propylene glycol diacrylate being di-functional monomer and 50 part by weight of dipentaerythritol hexaacrylate of 50 part by weight being hexa-functional monomer were used, respectively to obtain photosensitive monomer of 85 g.

As urethane acrylate oligomer obtained by polymerizing polyether polyol, hydroxyl radical-containing acrylic derivatives and a disocianate compound, 15 g of aliphatic diurethane acrylate oligomer having molecular weight of 4,000 was used. As photopolymer initiator, 15 g of 2-methyl-1 [4-(methylco)phenyl]-2-morpholine-propa-1-non (the model name "Micure MS-7" made by Miwon Commercial Co., Ltd.) was used. As a solvent, 215 g of propylene glycol monomethylether acetate (PGMEA) was used. Accordingly, photo cross linkable organics comprising the acrylic polymer, the photosensitive monomer, the urethane acrylate oligomer and the photopolymer initiator was completed.

Next, 95 g of Co₃O₄ was used as inorganic pigment and 95 g of Bi₂O₃-based glass powder was used as glass powder. As a dispersion agent, 12 g of alkyl ammonium of block high polymers having an acid radical, for example, the model name "Disperbyk-180" made by BYK-Chemie Co., Ltd. was used. 72 g of a solvent was used to disperse the inorganic pigment so that inorganic pigment dispersions were completed.

236 g of a solvent was additionally used to adjust viscosity of a final slurry so that a black matrix composition was provided.

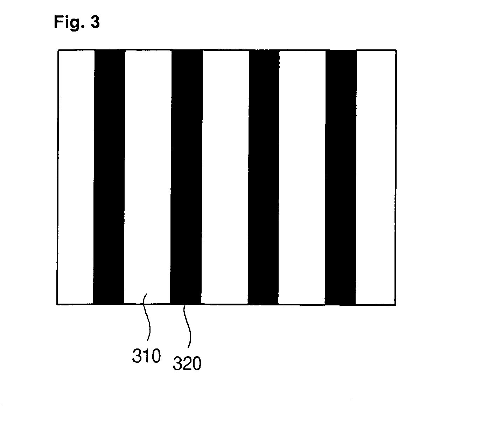

The black matrix composition is coated on a front substrate of a plasma display panel 310 to form a black matrix 320. The black matrix 320 thus formed is shown in FIG. 3. As shown in FIG. 3, an abnormal phenomenon of the black matrix 320 such as a cut off of the black matrix 320 or ununiformity of a width of the black matrix 320 is not generated.

[Example 2]

A black matrix composition was provided in the same manner as in Example 1 except that 70 g of Co₃O₄ was used as inorganic pigment and 70 g of Bi₂O₃-based glass powder was used as glass powder.

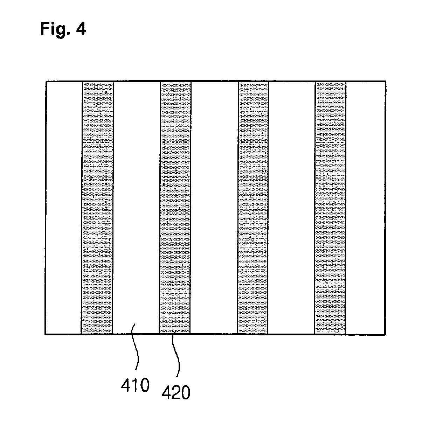

The black matrix composition is coated on a front substrate of a plasma display panel 410 to form a black matrix 420. The black matrix 420 thus formed is shown in FIG. 4. As shown in FIG. 4, an abnormal phenomenon of the black matrix 420 such as a cut off of the black matrix 420 or ununiformity of a width of the black matrix 420 is not generated.

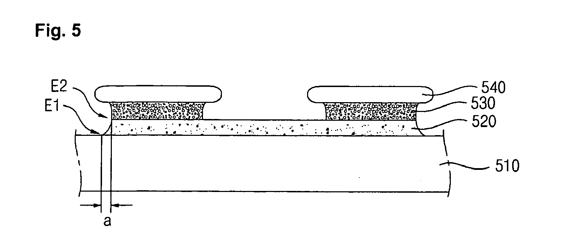

FIG. 5 shows a structure of a plasma display panel according to an embodiment of the present invention. Shown in FIG. 5, the plasma display panel according to an embodiment of the present invention comprises a substrate 510, a black matrix 520 formed on the substrate 510 and an electrode layer 530 formed on the black matrix 520. A width of one surface of the black matrix 520 contacting with the substrate 510, is more than the width of the other surface of the black matrix 520 contacting with the electrode layer 530. The black matrix(520) is formed with a black matrix paste or a black matrix slurry, and the black matrix paste or the black matrix slurry comprises photo cross linkable organics comprising urethane acrylate oligomer, inorganic pigment and glass powder.

Since the black matrix composition according to the present invention such as the black matrix paste or the black matrix slurry is the same as the above-described black matrix composition, a description thereof is omitted.

When the black matrix composition of the present invention develops according to a black matrix pattern, the width of one surface of the black matrix 520 contacting with the substrate 510, is more than the width of the other surface of the black matrix 520 contacting with the electrode layer 530 by reason of an increase of an adhesiveness between the substrate 510 and the black matrix(520).

A horizontal distance a between the edge E1 of the one surface and the edge E2 of the other surface, is more than or equal to 0.1 *µ*m to equal to or less than 10 *µ*m. Preferably, The horizontal distance a between the edge E1 of the one surface and the edge E2 of the other surface, is more than or equal to 5 *µ*m to equal to or less than 10 *µ*m.

The reference numeral 540 of FIG.5 is a DFR layer.

The embodiment of the invention being thus described, the same may be varied in many ways. Such variations are not to be regarded as a departure from the spirit and scope of the invention, and all such modifications as would be obvious to one skilled in the art are intended to be included within the scope of the following claims.

## Claims

1. A black matrix composition for a plasma display panel comprising:
20 to 85 weight percent, based on total weight of the black matrix composition, of photo cross linkable organics;
10 to 40 weight percent, based on total weight of the black matrix composition, of inorganic pigment; and
5 to 40 weight percent, based on total weight of the black matrix composition, of glass powder,
wherein the photo cross linkable organics comprises 0.5 to 30 weight percent, based on total weight of the photo cross linkable organics, of urethane acrylate oligomer.

2. The black matrix composition for the plasma display panel of claim 1, wherein the photo cross linkable organics further comprises 15 to 55 weight percent, based on total weight of the photo cross linkable organics, of acrylic polymer, 20 to 40 weight percent, based on total weight of the photo cross linkable organics, of photosensitive monomer and 4 to 15 weight percent, based on total weight of the photo cross linkable organics, of photopolymer initiator.

3. The black matrix composition for the plasma display panel of claim 1, wherein a number-average molecular weight of the urethane acrylate oligomer ranges from 500 to 40,000.

4. The black matrix composition for the plasma display panel of claim 1, wherein the inorganic pigment comprises either metal based inorganic pigment or metal oxide based inorganic pigment.

5. The black matrix composition for the plasma display panel of claim 2, where number-average molecular weight of the acrylic polymer ranges from 1,000 to 100,000.

6. The black matrix composition for the plasma display panel of claim 2, wherein the acrylic polymer comprises either terpolymer of benzyl methacylate, methacrylic acid and hydroxyethylmethacrylate, or terpolymer of benzyl methacylate, methacrylic acid and methyl methacrylate.

7. The black matrix composition for the plasma display panel of claim 5, wherein the acrylic polymer comprises either terpolymer of benzyl methacylate, methacrylic acid and hydroxyethylmethacrylate, or terpolymer of benzyl methacylate, methacrylic acid and methyl methacrylate.

8. The black matrix composition for the plasma display panel of claim 2, wherein the photosensitive monomer comprises mono-functional monomer comprising one acrylate functional group.

9. The black matrix composition for the plasma display panel of claim 2, wherein the photosensitive monomer comprises mono-functional monomer comprising one acrylate function group, and multi-functional monomer comprising two or more acrylate functional groups.

10. The black matrix composition for the plasma display panel of claim 2, wherein the photosensitive monomer comprises mono-functional monomer comprising one acrylate function group, and silane based monomer.

11. The black matrix composition for the plasma display panel of claim 2, wherein the photosensitive monomer comprises two or more multi-functional monomers, and
each of the multi-functional monomers comprises two or more acrylate functional groups.

12. The black matrix composition for the plasma display panel of claim 9, wherein the multi-functional monomer comprises any one of propylene glycol diacrylate, pentaerythritol triacrylate and dipentaerythritol hexaacrylate.

13. The black matrix composition for the plasma display panel of claim 11, wherein the multi-functional monomer comprises any one of propylene glycol diacrylate, pentaerythritol triacrylate and dipentaerythritol hexaacrylate.

14. The black matrix composition for the plasma display panel of claim 1, wherein the glass powder comprises either a lead oxide based compound or a bismuth based compound.

15. The black matrix composition for the plasma display panel of claim 2, wherein the photopolymer initiator comprises either benzophenone based initiator or trizine based initiator.

16. The black matrix composition for the plasma display panel of claim 1, wherein the black matrix composition for the plasma display panel is either a black matrix paste or a black matrix slurry.

17. A plasma display panel comprising:
a substrate;
a black matrix formed on the substrate; and
an electrode layer formed on the black matrix,
wherein a width of one surface of the black matrix contacting with the substrate, is more than the width of the other surface of the black matrix contacting with the electrode layer.

18. The plasma display panel of claim 17, wherein the horizontal distance between the edge of the one surface and the edge of the other surface, is more than or equal to 0.1 *µ*m to equal to or less than 10 *µ*m.

19. The plasma display panel of claim 17, wherein the horizontal distance between the edge of the one surface and the edge of the other surface, is more than or equal to 5 *µ*m to equal to or less than 10 *µ*m.

20. The plasma display panel of claim 17, wherein the black matrix is formed with a black matrix paste or a black matrix slurry, and the black matrix paste or the black matrix slurry comprises photo cross linkable organics comprising urethane acrylate oligomer, inorganic pigment and glass powder.

21. The plasma display panel of claim 20, wherein the photo cross linkable organics ranges from 20 to 85 weight percent based on total weight of the black matrix composition, and the inorganic pigment ranges from 10 to 40 weight percent based on total weight of the black matrix composition, and the glass powder ranges from 5 to 40 weight percent based on total weight of the black matrix composition, and
wherein the urethane acrylate oligomer ranges from 0.5 to 30 weight percent based on total weight of the photo cross linkable organics.

22. The plasma display panel of claim 21, wherein the photo cross linkable organics further comprises 15 to 55 weight percent, based on total weight of the photo cross linkable organics, of acrylic polymer, 20 to 40 weight percent, based on total weight of the photo cross linkable organics, of photosensitive monomer and 4 to 15 weight percent, based on total weight of the photo cross linkable organics, of photopolymer initiator.

23. The plasma display panel of claim 20, wherein a number-average molecular weight of the urethane acrylate oligomer ranges from 500 to 40,000.

24. The plasma display panel of claim 20, wherein the black matrix paste or the black matrix slurry further comprises at least one of a labeling agent, a silane based coupling agent, an anti-foaming agent, a plasticizer, a dispersing agent, or a dispersion maintaining agent.
